# DEMANDE DE BREVET EUROPEEN

(11) **EP 4 561 287 A1**
(43) Date de publication de la demande: **28.05.2025**
(21) Numéro de dépôt: 24214566.2
(22) Date de dépôt: 21.11.2024
(51) Int. Cl.: H05K 9/00

(54) **MODULE ÉLECTRONIQUE COMPORTANT UNE CARTE ÉLECTRONIQUE, UN BOÎTIER ET UNE CLOISON DE PROTECTION**

(30) Priorité: 23.11.2023 FR 2312941
(71) Demandeur: Valeo eAutomotive Germany GmbH, 91056 Erlangen (DE)
(72) Inventeur: LEBRASSEUR, Patrick, 95892 Cergy Pontoise (FR); DENIOT, Roger, 95892 Cergy Pontoise (FR)
(74) Mandataire: Valeo Powertrain Systems

(57) **Abrégé**

L'invention concerne un module électronique comportant :
- Une carte électronique (1),
- Un boîtier (2) dans lequel est placée la carte électronique,
- Une cloison de protection (3) fixée sur le boîtier et la carte électronique, de sorte que la carte électronique soit prise entre le boîtier et la cloison de protection,
- Au moins un élément de fixation (20) arrangé pour solidariser la carte électronique, le boitier et la cloison de protection,
caractérisé en ce que :
- le boîtier (2) et la cloison de protection (3) sont en matériaux électriquement conducteurs,
- le boîtier (2), la carte électronique et la cloison de protection (3) sont fixés ensemble par l'au moins un élément de fixation,
- au moins un élément de fixation (20) comporte une zone de contact électrique, et assure en outre un contact électrique entre le boîtier (2), la cloison de protection (3) et une masse électrique de la carte électronique.

## Description

La présente invention concerne un module électronique comportant une carte électronique, un boîtier et une cloison de protection.

Ce module électronique peut être intégré à un véhicule à propulsion hybride ou purement électrique, par exemple une automobile. Plus globalement, « véhicule » englobe au sens de la présente demande toute forme de mobilité à propulsion purement électrique, hybride, thermique ou autre. « Véhicule » englobe ainsi un engin roulant sur terre via quatre, trois, deux roues ou tout autre nombre de roues, ou un engin se déplaçant dans les airs ou sur l'eau, voire dans l'espace.

Il est connu de placer une carte électronique dans un boîtier isolant permettant de protéger les pièces environnantes des champs magnétiques émis par cette carte électronique pendant son fonctionnement.

L'objectif de l'invention est d'améliorer la réalisation de cette fonction de protection électromagnétique en diminuant l'espace dédié à cette fonction sur la carte électronique, et en réduisant les coûts nécessaires à cette protection électromagnétique.

L'invention concerne un module électronique comportant :
- Une carte électronique,
- Un boîtier dans lequel est placée la carte électronique,
- Une cloison de protection fixée sur le boîtier et la carte électronique, de sorte que la carte électronique soit prise entre le boîtier et la cloison de protection,
- Au moins un élément de fixation arrangé pour solidariser la carte électronique, le boitier et la cloison de protection,
caractérisé en ce que :
- le boîtier et la cloison de protection sont en matériaux électriquement conducteurs,
- le boîtier, la carte électronique et la cloison de protection sont fixés ensemble par l'au moins un élément de fixation,
- au moins un élément de fixation comporte une zone de contact électrique, et assure en outre un contact électrique entre le boîtier, la cloison de protection et une masse électrique de la carte électronique.

Selon un aspect de l'invention, le boîtier et la cloison de protection forment une enceinte de protection électromagnétique, arrangée pour isoler la carte électronique, et protéger la carte électronique de l'extérieur, notamment de perturbations électromagnétiques.

Selon un aspect de l'invention, l'enceinte de protection électromagnétique est également arrangée pour protéger l'environnement extérieur des champs électromagnétiques produits par la carte électronique.

Selon un aspect de l'invention, la carte électronique comprend un substrat plat, sur lequel sont soudés des composants électroniques.

Selon un aspect de l'invention, des composants électroniques sont soudés sur chaque face du substrat plat.

Alternativement, l'ensemble des composants électroniques sont soudés sur une face du substrat plat.

Selon un aspect de l'invention, une face de la carte électronique est placée au contact du boîtier. On nommera cette face la face inférieure de la carte électronique.

Selon un aspect de l'invention, une face de la carte électronique est au contact électrique de la cloison de protection. On nommera cette face la face supérieure de la carte électronique.

Selon un aspect de l'invention, le boîtier est en aluminium.

Selon un aspect de l'invention, la cloison de protection est en aluminium.

Selon un aspect de l'invention, le boîtier comprend un fond, notamment fond sensiblement plat.

Selon un aspect de l'invention, le boîtier comprend une bordure périphérique, sensiblement perpendiculaire au fond du boîtier, et entourant le fond du boîtier.

Selon un aspect de l'invention, la bordure périphérique et le fond du boîtier forment une cuve, dans laquelle est placée la carte électronique.

Selon un aspect de l'invention, le boîtier comprend au moins une zone de contact, arrangée pour être placée au contact de la carte électronique lors de l'assemblage du module électronique.

Selon un aspect de l'invention, le boîtier contient une pluralité de zones de contact, appelées zones de contact du boîtier.

Selon un aspect de l'invention, au moins une des zones de contact du boîtier est une bordure de support.

Une bordure de support est une zone de contact du boîtier juxtaposée à la bordure périphérique du boîtier.

Selon un aspect de l'invention, le boîtier comprend au moins un plot de contact.

Selon un aspect de l'invention, les plots de contact sont des volumes du boîtiers placés sur le fond du boîtier.

Selon un aspect de l'invention, chaque plot de contact comprend une surface supérieure plane.

Selon un aspect de l'invention, les plots de contact sont de forme ronde.

Alternativement, les plots de contact peuvent être de toute autre forme, notamment de forme rectangulaire, ou ovale.

Selon un aspect de l'invention, les surfaces supérieures des plots de contact du boîtier sont des zones de contact du boîtier.

Selon un aspect de l'invention, au moins une zone de contact du boîtier est une zone de contact électrique du boîtier et est arrangée pour garantir un contact électrique entre le boîtier et une masse électrique de la carte électronique.

Selon un aspect de l'invention, l'ensemble des zones de contact du boîtier sont planes et coplanaires, et définissent un plan de contact du boîtier.

Selon un aspect de l'invention, le plan de contact du boîtier est parallèle au fond du boîtier.

Selon un aspect de l'invention, le plan de contact du boîtier est surélevé par rapport au fond du boîtier.

Par exemple, le plan de contact est surélevé du fond du boîtier d'une hauteur H1 supérieure à 20mm.

Selon un aspect de l'invention, la hauteur H1 est supérieure à l'épaisseur maximale des composants électroniques soudés sur la face inférieure de la carte électronique, de sorte à ce que les composants électroniques soudés sur la face inférieure de la carte électronique ne soient pas en contact avec le boîtier une fois la carte électronique placée en contact électrique avec le boîtier.

Selon un aspect de l'invention, le fond du boîtier, la bordure périphérique du boîtier, la bordure de support et les plots de contact sont fabriqués d'un seul bloc, par exemple par moulage, ou par usinage.

Par conséquent, l'ensemble des zones de contact électrique du boîtier sont connectées électriquement.

Selon un aspect de l'invention, la cloison de protection est de forme sensiblement planaire. On définit un plan principal de la cloison de protection.

Selon un aspect de l'invention, la cloison de protection contient une pluralité de zones de contact, appelées zones de contact de la cloison de protection et arrangées pour être placée au contact de la carte électronique lors de l'assemblage du module électronique.

Selon un aspect de l'invention, au moins une des zones de contact de la cloison de protection est une bordure de contact de la cloison de protection.

Une bordure de contact de la cloison de protection est une zone de contact juxtaposée à la périphérie de la cloison de protection.

Selon un aspect de l'invention, la cloison de protection comprend au moins une zone de contact centrale.

Les zones de contact centrales sont des zones de contact de la cloison de protection n'étant pas reliées à la périphérie de la cloison de protection.

Selon un aspect de l'invention, au moins une zone de contact de la cloison de protection est une zone de contact électrique de la cloison de protection, et est arrangée pour garantir un contact électrique entre la cloison de protection et une masse électrique de la carte électronique.

Selon un aspect de l'invention, l'ensemble des zones de contact de la cloison de protection sont planes et coplanaires, et définissent un plan de contact de la cloison de protection.

Selon un aspect de l'invention, le plan de contact de la cloison de protection est parallèle au plan principal de la cloison de protection.

Selon un aspect de l'invention, le plan de contact de la cloison de protection est décalé par rapport au plan principal de la cloison de protection d'une hauteur H2 supérieure à 12mm.

Selon un aspect de l'invention, la hauteur H2 est supérieure à l'épaisseur maximale des composants électroniques soudés sur la face supérieure de la carte électronique, de sorte à ce que les composants électroniques soudés sur la face supérieure de la carte électronique ne soient pas en contact électrique avec la cloison de protection une fois la carte électronique placée en contact électrique avec la cloison de protection.

Selon un aspect de l'invention, la carte électronique comprend :
- sur la face supérieure, au moins une zone de contact supérieure de la carte électronique,
- sur la face inférieure, au moins une zone de contact inférieure de la carte électronique.

Selon un aspect de l'invention, au moins une zone de contact supérieure de la carte électronique est une zone de contact électrique supérieure de la carte électronique.

Selon un aspect de l'invention, au moins une zone de contact inférieure de la carte électronique est une zone de contact électrique inférieure de la carte électronique.

Selon un aspect de l'invention, les zones de contact électrique supérieures et les zones de contact électrique inférieures de la carte électronique sont connectées électriquement à la masse de la carte électronique.

Selon un aspect de l'invention, les zones de contact supérieures de la carte électronique sont placées en regard des zones de contact de la cloison de protection, et sont en contact avec ces zones de contact de la cloison de protection.

Selon un aspect de l'invention, les zones de contact inférieures de la carte électronique sont placées en regard des zones de contact du boîtier, et sont en contact avec ces zones de contact du boîtier.

Ainsi, la carte électronique est maintenue fixée entre le boîtier et la cloison de protection.

Selon un aspect de l'invention, les zones de contact électrique inférieures de la carte électronique sont placées en regard des zones de contact électrique du boîtier, et sont en contact électrique avec ces zones de contact électrique du boîtier.

Selon un aspect de l'invention, les zones de contact électrique supérieures de la carte électronique sont placées en regard des zones de contact électrique de la cloison de protection, et sont en contact électrique avec ces zones de contact électrique de la cloison de protection

Ainsi, l'ensemble du boîtier et de la cloison de protection sont électriquement connectés à la masse électrique de la carte électronique.

Au moins une zone de contact du boîtier est placée en regard d'au moins une zone de contact de la cloison de protection.

Au moins une zone de contact électrique du boîtier est placée en regard d'au moins une zone de contact électrique de la cloison de protection.

On nomme élément de fixation une combinaison de caractéristiques du module électronique permettant de solidariser le boîtier, la carte électronique, et la cloison de protection.

Un élément de fixation comprend :
- une caractéristique géométrique de la carte électronique,
- une caractéristique géométrique de la cloison de protection,
- une caractéristique géométrique du boîtier
- et éventuellement au moins une pièce de fixation

Un élément de fixation comprend :
- une portion d'une zone de contact électrique supérieure de la carte électronique,
- une portion d'une zone de contact électrique inférieure de la carte électronique,
ces deux zones de contact étant placées en regard l'une de l'autre,
- une portion d'une zone de contact électrique du boîtier placée en regard de la portion d'une zone de contact électrique inférieure de la carte électronique,
- une portion d'une zone de contact électrique de la cloison de protection placée en regard de la portion d'une zone de contact électrique supérieure de la carte électronique,

Par exemple, un élément de fixation comprend :
- un perçage dans la carte électronique,
- un perçage dans la cloison de protection,
- un perçage dans le boîtier,
ces perçages étant coaxiaux, et
- une vis traversant l'ensemble des perçages et fixant mécaniquement la cloison de protection, le boîtier, et la carte électronique.

Selon un autre mode de réalisation, une zone de fixation comprend :
- un perçage de fixation dans la carte électronique
- un perçage respectivement dans le boîtier ou la cloison de protection,
- un plot de fixation formé respectivement dans la cloison de protection ou le boîtier,
le plot de fixation étant arrangé pour être inséré en force dans les perçages pour fixer mécaniquement la cloison de protection, le boîtier, et la carte électronique.

Le module électronique comprend un capot formant une cuve, arrangé pour être placé sur le boîtier afin de refermer le boîtier.

L'utilisation des éléments de fixation pour réaliser le contact électrique entre la carte électronique, la cloison de protection et le boîtier permet avantageusement de réduire l'espace nécessaire alloué sur la carte pour la fonction de protection électromagnétique. Cela permet ainsi de diminuer l'encombrement de la carte électronique, et de diminuer les coûts de production.

D'autres caractéristiques, détails et avantages de l'invention ressortiront plus clairement à la lecture de la description qui suit d'une part, et de plusieurs exemples de réalisation donnés à titre indicatif et non limitatif en référence aux dessins schématiques annexés d'autre part, sur lesquels :
[Fig 1] La figure 1 est une représentation schématique d'un boîtier selon l'invention.
[Fig. 2] La figure 2 est une représentation schématique de l'assemblage d'un boîtier et d'une carte électronique selon l'invention.
[Fig. 3] La figure 3 est une représentation schématique d'une cloison de protection selon l'invention.
[Fig. 4] La figure 4 est une représentation schématique de l'assemblage d'un boîtier, d'une carte électronique et d'une cloison de protection selon l'invention.
[Fig. 5] La figure 5 est une représentation schématique de l'assemblage d'un module électronique selon l'invention.
[Fig. 6] La figure 6 est une représentation en coupe de l'assemblage d'un module électronique de l'invention.
[Fig. 7] La figure 7 une vue rapprochée d'un élément de fixation d'un module électronique selon l'invention.

Les caractéristiques, variantes et les différentes formes de réalisation de l'invention peuvent être associées les unes avec les autres, selon diverses combinaisons, dans la mesure où elles ne sont pas incompatibles ou exclusives les unes par rapport aux autres. On pourra notamment imaginer des variantes de l'invention ne comprenant qu'une sélection de caractéristiques décrites par la suite de manière isolée des autres caractéristiques décrites, si cette sélection de caractéristiques est suffisante pour conférer un avantage technique et/ou pour différencier l'invention par rapport à l'état de la technique antérieur.

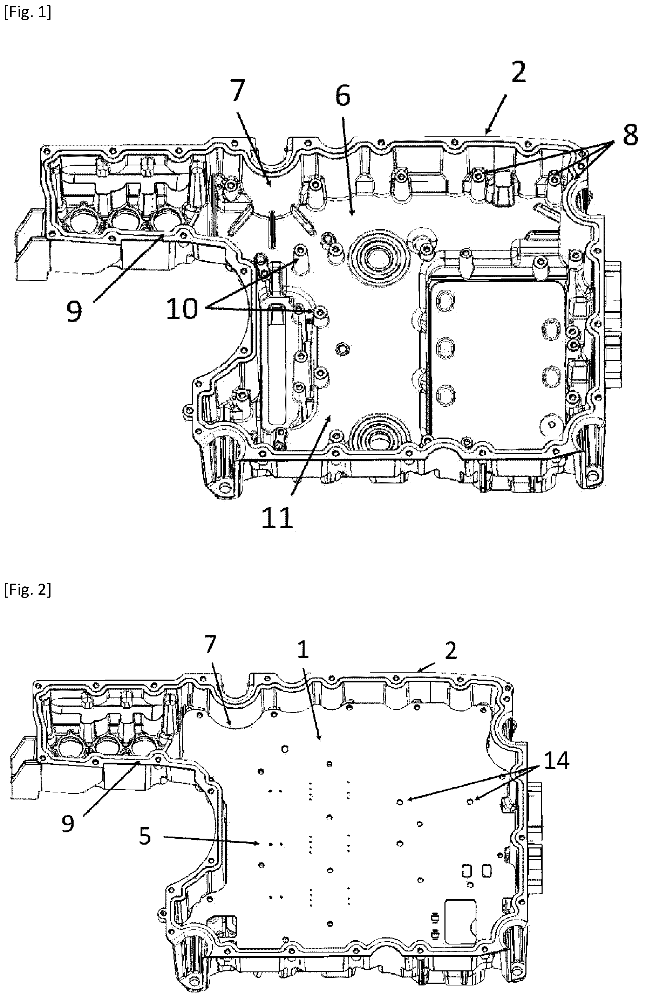

On a représenté sur la figure 1 un boîtier 2 d'un module électronique 100 comprenant un fond 6 sensiblement plat.

Le boîtier comprend au moins une zone de contact du boîtier 8, arrangée pour être placée au contact de la carte électronique 1 lors de l'assemblage du module électronique 100.

Le boîtier 2 comprend une bordure périphérique 7 sensiblement perpendiculaire au fond du boîtier et entourant le fond du boîtier 6.

La bordure périphérique 7 et le fond du boîtier forment une cuve 11, dans laquelle est placée la carte électronique.

Le boîtier 2 contient une pluralité de zones de contact du boîtier 8.

Une des zones de contact du boîtier 8 est une bordure de support 9, c'est-à-dire une zone de contact du boîtier 8 juxtaposée à la bordure périphérique 7 du boîtier.

Le boîtier comprend une face supérieure 12, notamment une face supérieure plane et parallèle au fond du boîtier 6.

La bordure de support 9 est de largeur sensiblement constante, et s'étend le long de l'ensemble de la bordure périphérique 7.

Le boîtier 2 comprend au moins un plot de contact 10, c'est-à-dire un volume du boîtier placé sur le fond du boîtier 6. Chaque plot de contact comprend une surface supérieure plane 13, ces surfaces supérieures étant des zones de contact du boîtier.

Les plots de contact 10 sont de forme ronde.

Selon un autre mode de réalisation non représenté, les plots de contact 10 peuvent être de toute autre forme, notamment de forme rectangulaire, ou ovale.

Au moins une zone de contact du boîtier 8 est une zone de contact électrique du boîtier et est arrangée pour garantir un contact électrique entre le boîtier 2 et une masse électrique de la carte électronique 1.

Le fond du boîtier 6, la bordure périphérique du boîtier 7, la bordure de support 9 et les plots de contact 10 sont fabriqués d'un seul bloc, par exemple par moulage, ou par usinage.

Par conséquent, l'ensemble des zones de contact électrique du boîtier sont connectées électriquement.

On a représenté sur la figure 2 l'assemblage d'un boîtier 2 tel qu'illustré sur la figure 1 et d'une carte électronique 1 selon l'invention.

La carte électronique 1 est placée dans le boîtier 2.

Elle comprend un substrat plat 5 sur lequel sont soudés des composants électroniques, non représentés ici.

Des composants électroniques sont soudés sur chaque face du substrat plat 5, ou sur une seule des faces du substrat plat.

La carte électronique 1 comprend :
- sur la face supérieure, au moins une zone de contact supérieure 14 de la carte électronique,
- sur la face inférieure, au moins une zone de contact inférieure 15 de la carte électronique, non visible sur cette figure.

La face inférieure de la carte électronique est placée au contact du boîtier 2.

Au moins une zone de contact supérieure 14 de la carte électronique 1 est une zone de contact électrique supérieure de la carte électronique, et au moins une zone de contact inférieure 15 de la carte électronique est une zone de contact électrique inférieure de la carte électronique.

Ces zones de contact électrique supérieure et inférieure sont connectées électriquement à la masse de la carte électronique 1.

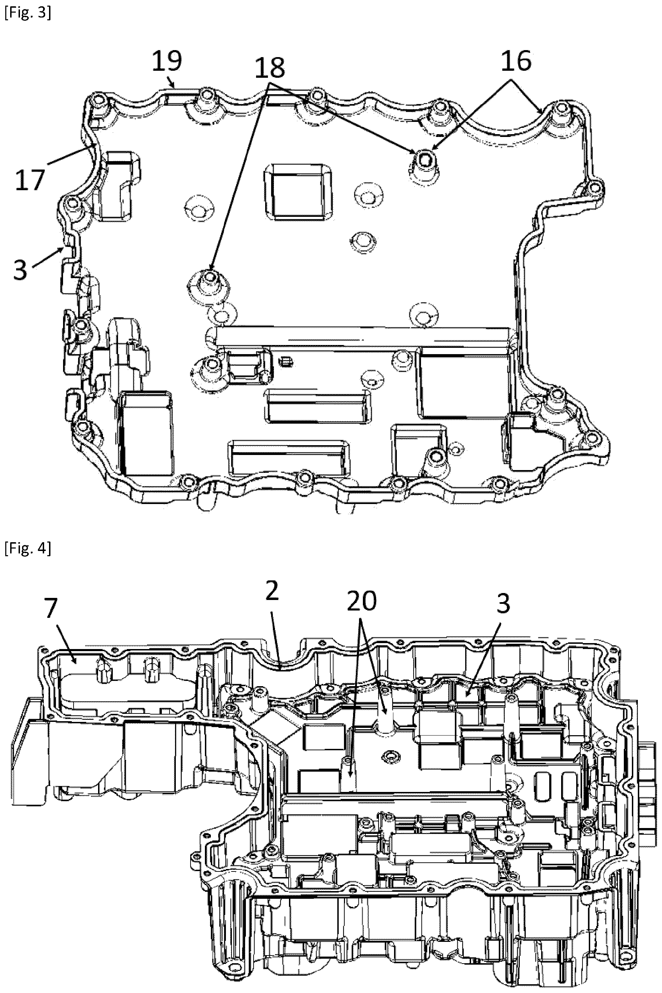

On a représenté sur la figure 3 une cloison de protection selon l'invention.

La cloison de protection 3 est de forme sensiblement planaire. On définit donc un plan principal de la cloison de protection.

La cloison de protection 3 contient une pluralité de zones de contact, appelées zones de contact de la cloison de protection 16. Ces zones de contact de la cloison de protection sont planes et coplanaires, et définissent un plan de contact de la cloison de protection.

Une des zones de contact de la cloison de protection 16 est une bordure de contact de la cloison de protection 17, à savoir une zone de contact juxtaposée à la périphérie de la cloison de protection.

La cloison de protection 3 également une pluralité de zones de contact centrales 18.

Les zones de contact centrales 18 sont des zones de contact de la cloison de protection 16 n'étant pas reliées à la périphérie de la cloison de protection 19.

Au moins une zone de contact de la cloison de protection 16 est une zone de contact électrique de la cloison de protection, et est arrangée pour garantir un contact électrique entre la cloison de protection 3 et une masse électrique de la carte électronique 1.

On a représenté sur la figure 4 l'assemblage d'un boîtier 2, d'une carte électronique 1 et d'une cloison de protection 3.

La cloison de protection 3 est fixée sur le boîtier 2 et la carte électronique 1, de sorte que la carte électronique soit prise entre le boîtier et la cloison de protection.

Le boîtier 2 et la cloison de protection 1 forment une enceinte de protection électromagnétique arrangée pour isoler la carte électronique, la protéger de perturbations électromagnétiques, et pour protéger l'environnement extérieur des champs électromagnétiques produits par la carte électronique.

Le boîtier 2 et la cloison de protection 3 sont en matériaux électriquement conducteurs, par exemple en aluminium.

Les zones de contact inférieures 14 de la carte électronique sont placées en regard des zones de contact du boîtier 8, et sont en contact avec ces zones de contact électrique du boîtier.

Par ailleurs, les zones de contact supérieures de la carte électronique 15 sont placées en regard des zones de contact de la cloison de protection 16, et sont en contact avec ces zones de contact de la cloison de protection.

Ainsi, la carte électronique 1 est maintenue fixée entre le boîtier 2 et la cloison de protection 3.

De plus, les zones de contact électrique inférieures de la carte électronique 1 sont placées en regard des zones de contact électrique du boîtier 2, en contact électrique avec ces zones de contact électrique du boîtier.

Les zones de contact électrique supérieures de la carte électronique 1 sont placées en regard des zones de contact électrique de la cloison de protection 3, en contact électrique avec ces zones de contact électrique de la cloison de protection.

Ainsi, l'ensemble du boîtier 2 et de la cloison de protection 3 sont électriquement connectés à la masse électrique de la carte électronique 1.

Au moins une zone de contact du boîtier 8 est placée en regard d'au moins une zone de contact de la cloison de protection 3, et au moins une zone de contact électrique du boîtier 2 est placée en regard d'au moins une zone de contact électrique de la cloison de protection 3, de part et d'autre de la carte électronique 1.

Le module électronique 100 comporte un ensemble d'éléments de fixation 20 arrangés pour solidariser la carte électronique 1, le boîtier 2 et la cloison de protection 3.

Le boîtier 2, la carte électronique et la cloison de protection 3 sont donc fixés ensemble par les éléments de fixation 20.

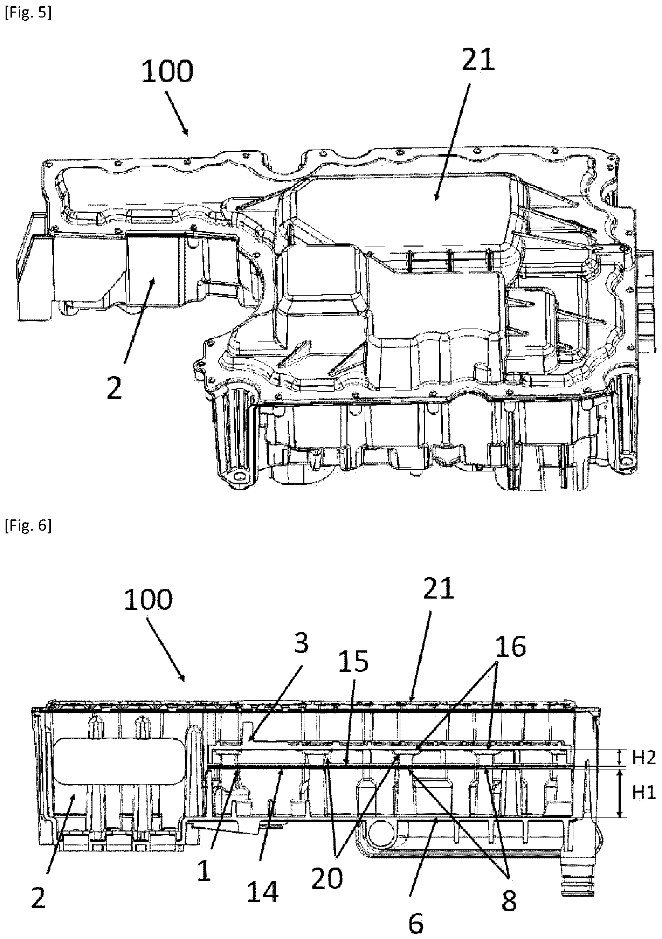

La figure 5 illustre l'assemblage d'un module électronique. Le module électronique 100 comprend un capot 21 formant une cuve, arrangé pour être placé sur le boîtier 2 afin de refermer le boîtier.

La figure 6 est une vue en coupe d'un module électronique 100 une fois assemblé, permettant de visualiser le placement de la carte électronique 1 entre le boîtier 2 et la cloison de protection 3.

L'ensemble des zones de contact du boîtier 8 sont planes et coplanaires, et définissent un plan de contact du boîtier, parallèle au fond du boîtier 6 et surélevé par rapport au fond du boîtier d'une hauteur supérieure à 12mm supérieure à l'épaisseur maximale des composants électroniques soudés sur la face inférieure de la carte électronique 14, de sorte à ce que les composants électroniques soudés sur la face inférieure de la carte électronique ne soient pas en contact avec le boîtier 2 une fois la carte électronique placée en contact électrique avec le boîtier.

Le plan de contact de la cloison de protection 3 est parallèle au plan principal de la cloison de protection, et est décalé par rapport au plan principal de la cloison de protection d'une hauteur H2 supérieure à 12mm, notamment supérieure à l'épaisseur maximale des composants électroniques soudés sur la face supérieure de la carte électronique 15, de sorte à ce que les composants électroniques soudés sur la face supérieure de la carte électronique ne soient pas en contact électrique avec la cloison de protection une fois la carte électronique placée en contact électrique avec la cloison de protection.

Par ailleurs, les zones de contact du boîtier 8 sont des zones de contact électrique du boitier, et sont arrangés pour garantir un contact électrique entre le boîtier 2 et une masse électrique de la carte électronique 1.

De même, les zones de contact de la cloison de protection 16 sont des zones de contact électrique de la cloison de protection, et sont arrangés pour garantir un contact électrique entre la cloison de protection 3 et une masse électrique de la carte électronique 1.

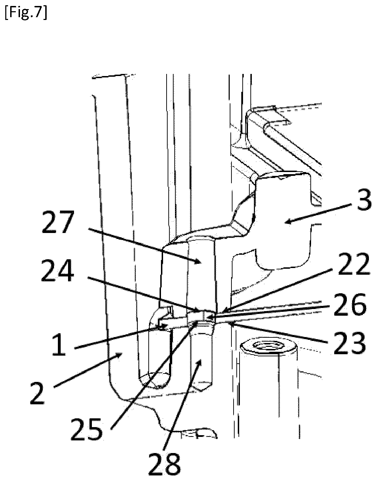

On a représenté sur la figure 7 un élément de fixation 20 selon un mode de réalisation de l'invention. Un élément de fixation est une combinaison de caractéristiques du module électronique permettant de solidariser le boîtier 2, la carte électronique 1, et la cloison de protection 3.

L'élément de fixation 20 comprend :
- une portion d'une zone de contact électrique supérieure 22 de la carte électronique 1,
- une portion d'une zone de contact électrique inférieure 23 de la carte électronique 1,
ces deux zones de contact étant placées en regard l'une de l'autre,
- une portion d'une zone de contact électrique du boîtier 24 placée en regard de la portion d'une zone de contact électrique inférieure de la carte électronique,
- une portion d'une zone de contact électrique de la cloison de protection 25 placée en regard de la portion d'une zone de contact électrique supérieure de la carte électronique,

L'élément de fixation comprend également :
- un perçage dans la carte électronique 26,
- un perçage dans la cloison de protection 27,
- un perçage dans le boîtier 28,
ces perçages étant coaxiaux, et
- une vis traversant l'ensemble des perçages, non représentée ici, fixant mécaniquement la cloison de protection, le boîtier, et la carte électronique.

Selon un autre mode de réalisation non représenté, l'élément de fixation comprend :
- un perçage de fixation dans la carte électronique
- un perçage respectivement dans le boîtier ou la cloison de protection,
- un plot de fixation formé respectivement dans la cloison de protection ou le boîtier, et le plot de fixation étant arrangé pour être inséré en force dans les perçages pour fixer mécaniquement la cloison de protection, le boîtier, et la carte électronique.

L'élément de fixation comporte une zone de contact électrique, et assure en outre un contact électrique entre le boîtier, la cloison de protection et une masse électrique de la carte électronique.

## Revendications

1. Module électronique (100) comportant :
- Une carte électronique (1),
- Un boîtier (2) dans lequel est placée la carte électronique,
- Une cloison de protection (3) fixée sur le boîtier et la carte électronique, de sorte que la carte électronique soit prise entre le boîtier et la cloison de protection,
- Au moins un élément de fixation (20) arrangé pour solidariser la carte électronique, le boitier et la cloison de protection,
**caractérisé en ce que** :
- le boîtier (2) et la cloison de protection (20) sont en matériaux électriquement conducteurs,
- le boîtier (2), la carte électronique (1) et la cloison de protection (3) sont fixés ensemble par l'au moins un élément de fixation,
- au moins un élément de fixation (20) comporte une zone de contact électrique, et assure en outre un contact électrique entre le boîtier (2), la cloison de protection (3) et une masse électrique de la carte électronique (1).

2. Module électronique (100) selon la revendication 1, dans lequel le boîtier (2) et la cloison de protection (3) forment une enceinte de protection électromagnétique arrangée pour protéger l'environnement extérieur des champs électromagnétiques produits par la carte électronique (1), et la carte électronique de l'environnement extérieur, notamment de perturbations électromagnétiques.

3. Module électronique (100) selon l'une des revendications précédentes, dans lequel une face de la carte électronique (1) nommée face inférieure de la carte électronique est placée au contact du boîtier (2) et une face de la carte électronique nommée face supérieure de la carte électronique est au contact électrique de la cloison de protection (3).

4. Module électronique (100) selon l'une des revendications précédentes, dans lequel le boîtier (2) comprend un fond (6), notamment fond sensiblement plat, et une bordure périphérique (7), sensiblement perpendiculaire au fond du boîtier (6) et entourant le fond du boîtier.

5. Module électronique (100) selon l'une des revendications précédentes, dans lequel le boîtier (2) comprend au moins une zone de contact (8), arrangée pour être placée au contact de la carte électronique (1) lors de l'assemblage du module électronique.

6. Module électronique (100) selon l'une des revendications précédentes, dans lequel le boîtier (2) comprend au moins un plot de contact (10), c'est-à-dire au moins un volume du boîtier placé sur le fond du boîtier.

7. Module électronique (100) selon la revendication 5, et éventuellement selon la revendication 6, dans lequel au moins une zone de contact (8) du boîtier (2) est une zone de contact électrique du boitier et est arrangée pour garantir un contact électrique entre le boîtier (2) et une masse électrique de la carte électronique (1).

8. Module électronique (100) selon les revendications 4 et 6, et éventuellement selon la revendication 7, dans lequel le fond du boîtier (6), la bordure périphérique du boîtier (7) et les plots de contact (10) sont fabriqués d'un seul bloc, par exemple par moulage, ou par usinage.

9. Module électronique (100) selon la revendication 3, et éventuellement l'une
des revendications 4 à 7, dans lequel la carte électronique (1) comprend :
- sur la face supérieure, au moins une zone de contact supérieure de la carte électronique (14),
- sur la face inférieure, au moins une zone de contact inférieure de la carte électronique (15),
au moins une zone de contact supérieure de la carte électronique étant une zone de contact électrique supérieure de la carte électronique, et au moins une zone de contact inférieure de la carte électronique étant une zone de contact électrique inférieure de la carte électronique.

10. Module électronique (100) selon l'une des revendications précédentes, dans lequel la cloison de protection (3) contient une pluralité de zones de contact (18), appelées zones de contact de la cloison de protection et arrangées pour être placée au contact de la carte électronique (1) lors de l'assemblage du module électronique.

11. Module électronique (100) selon la revendication 10, dans lequel au moins une zone de contact de la cloison de protection (18) est une zone de contact électrique de la cloison de protection, et est arrangée pour garantir un contact électrique entre la cloison de protection (3) et une masse électrique de la carte électronique (1).

12. Module électronique (100) selon les revendications 7, 9 et 11, dans lequel un élément de fixation (20) comprend :
- une portion d'une zone de contact électrique supérieure (14) de la carte électronique,
- une portion d'une zone de contact électrique inférieure (15) de la carte électronique,
ces deux zones de contact étant placées en regard l'une de l'autre,
- une portion d'une zone de contact électrique du boîtier (2) placée en regard de la portion d'une zone de contact électrique inférieure de la carte électronique (1),
- une portion d'une zone de contact électrique de la cloison de protection (3) placée en regard de la portion d'une zone de contact électrique supérieure de la carte électronique (1).
